# EUROPÄISCHE PATENTSCHRIFT

(11) **EP 3 693 986 B1**
(45) Veröffentlichungstag und Bekanntmachung des Hinweises auf die Patenterteilung: **29.05.2024**
(21) Anmeldenummer: 20155355.9
(22) Anmeldetag: 04.02.2020
(51) Int. Cl.: H01H 9/38

(54) **VERFAHREN UND VORRICHTUNG ZUM DAUERHAFTEN TRENNEN EINES STROMKREISES MIT INDUKTIVER LAST DURCH ZEITVERSETZTES SCHALTEN ZWEIER IN REIHE GESCHALTETER SCHALTER**
METHOD AND DEVICE FOR PERMANENTLY SEPARATING A CIRCUIT WITH INDUCTIVE LOAD BY TIME-OFFSET SWITCHING OF TWO SERIES-CONNECTED SWITCHES
PROCÉDÉ ET DISPOSITIF DE DÉCONNEXION PERMANENTE D'UN CIRCUIT À CHARGE INDUCTIVE PAR COMMUTATION DIFFÉRÉ DE DEUX COMMUTATEURS MONTÉS EN SÉRIE

(30) Priorität: 05.02.2019 DE 102019102858
(43) Veröffentlichungstag der Anmeldung: 12.08.2020
(73) Patentinhaber: Lell, Peter, 85368 Moosburg (DE)
(72) Erfinder: Lell, Peter, 85368 Moosburg (DE)
(74) Vertreter: Eder Schieschke & Partner mbB

(56) Entgegenhaltungen:
- EP-A1- 0 231 469
- DE-A1-102014 107 853
- FR-A1- 2 905 796

## Beschreibung

Die Erfindung betrifft eine Vorrichtung zum dauerhaft sicheren Trennen eines Stromkreises mit hohen Strömen bei hohen Spannungen mit induktiver Last gemäß Patentanspruch 1. Ebenso betrifft die vorliegende Erfindung auch einen Stromkreis gemäß Patentanspruch 9, der neben der erfindungsgemäßen Vorrichtung auch eine Spannungsquelle, einen Lastwiderstand und eine induktive Last aufweist, sowie ein Verfahren unter Verwendung der erfindungsgemäßen Vorrichtung gemäß Patentanspruch 10.

Eine Trennung von Stromkreisen mit hohen Strömen bei hohen Spannungen ist oft nur mit Schaltern möglich, die einen hohen Energieeintrag verkraften, ohne dabei zerstört zu werden. Hierfür werden bisher oft Schalter eingesetzt, die einen Trennbereich aufweisen, der innerhalb eines Löschmittels vorliegt oder an dem zumindest ein Löschmittel anliegt. Durch das Löschmittel soll ein Lichtbogen gelöscht, verarmt oder zumindest gestört werden, der nach der Trennung des Trennbereichs entsteht. Ursache für die Entstehung eines Lichtbogens ist die im Augenblick der Stromtrennung in der Kreisinduktivität in Form eines Magnetfeldes gespeicherte Energie, die gleich nach der Trennung in den Schalter eingebracht wird. Das heißt, ein energiereicher Lichtbogen tritt insbesondere bei der Trennung von Stromkreisen mit hoher induktiver Last auf. Nachdem die meisten Löschmittel und Kunststoffe Kohlenstoffatome enthalten, werden diese Atome in der extremen Lichtbogenhitze von weit über 2000°C zerlegt und bilden dann bei Abkühlung eine elektrisch leitfähige Kohlenstoffschicht, oder die Lichtbogenhitze macht das Löschmittel ganz oder teilweise elektrisch leitfähig. Derartige Schalter können zwar Stromkreise bei hoher Quellspannung und hohen Stromstärken aktiv oder passiv abschalten, jedoch bestimmt hier die Induktivität des abzuschaltenden Stromkreises, ob dieser Schalter nach der Stromunterbrechung dann hochisolierend ist und bleibt oder später mehr oder weniger wieder leitfähig wird.

Gleiches gilt für im Schalter eingesetzte Materialien, die meist Halogenide wie Chlor oder Fluor enthalten - auch hier ist nach der Stromabschaltung bei im Schalter noch vorhandenem hocherhitztem Plasma die elektrische Leitfähigkeit zwar sehr klein, wird jedoch extrem hoch, wenn sich das Plasma nach erfolgter Trennung des Stromkreises abkühlt. Für die Abkühlzeit reichen hier bereits wenige Millisekunden aus. Folglich ist es mit solchen Schaltern zwar möglich, den Stromkreis zunächst zu unterbrechen, aber es kann keine dauerhaft sichere Trennung mit einem stets geforderten hohen Isolationswiderstand gewährleistet werden. Derzeit verwendete Schalter eignen sich zum Teil schon für die Abschaltung einer in Kraftfahrzeugen üblichen Spannung von 450 V bis 850 V und Strömen im Stromkreis im Augenblick des Trennens von bis zu 20 kA. Allerdings werden in Zukunft in diesem Bereich Spannungen von 1250 V und bei Bussen und LKWs sogar über 2000 V bei Trennströmen bis zu 30 kA erwartet, sodass die bisher verwendeten Schalter solche Stromkreise als Einzelbaugruppe nicht mehr dauerhaft und sicher abschalten können.

Die EP 0 231 469 A1 betrifft Leistungsschalter mit einer Kommutationsvorrichtung, einer parallel zur Kommutationsvorrichtung geschalteten Halbleiterventilanordnung, einer in Serie zur Halbleiterventilanordnung geschalteten Trennschaltstelle, und mit einer Steuerschaltung, zum Erfassen der Polarität des abzuschaltenden Stromes, zum Erfassen eines Ausschaltbefehls, zur Abgabe eines auf die Kommutationsvorrichtung wirkenden Ansprechbefehls, wenn der erfasste Strom in Durchlassrichtung der Halbleiterventilanordnung fließt, und zur Abgabe eines auf die Trennschaltstelle wirkenden Auslösebefehls, wenn der abzuschaltende Strom nach dem Ansprechen der Kommutationsvorrichtung in der Halbleiterventilanordnung unterbrochen ist, wobei die Halbleiterventilanordnung höchstens ein Halbleiterventil oder eine Serienschaltung mehrerer Halbleiterventile gleicher Durchlassrichtung enthält, und wobei die Kommutationsvorrichtung und die Trennschaltstelle durch mechanische Kopplung derart gesteuert sind, dass die Trennschaltstelle an einem Zeitpunkt öffnet, an welchem ein nach einem Nulldurchgang des abzuschaltenden Stromes durch die Halbleiterventilanordnung fliessender Ausräumstrom abgeklungen ist. Die EP 0 231 469 A1 offenbart nicht die Merkmale der kennzeichnenden Teile der Patentansprüche 1 und 10.

Es ist deshalb die Aufgabe der vorliegenden Erfindung, eine Möglichkeit bereitzustellen, Stromkreise mit hohen Strömen und hohen Spannungen mit hoher induktiver Last dauerhaft und sicher zu trennen, bei denen bisherige Hochstrom-Hochspannungsschalter versagen. Es soll dabei sicher verhindert werden, dass ein solcher Schalter nach dem Trennen innerhalb kurzer Zeit wieder leitfähig wird. Weiterhin soll verhindert werden, dass nach dem Schaltvorgang der Schalter durch bei unzureichendem Isolationswiderstand fließende hohe Dauerströme zerstört wird.

Diese Aufgabe wird durch die Bereitstellung einer erfindungsgemäßen Vorrichtung nach Anspruch 1, eines erfindungsgemäßen Stromkreises nach Anspruch 9 sowie eines erfindungsgemäßen Verfahrens nach Anspruch 10 gelöst.

Die erfindungsgemäße Vorrichtung zum Trennen eines Stromkreises mit induktiver Last weist eine(n) erste(n) und eine(n) zweite(n) Schalter/Schaltgruppe auf, die in Reihe zueinander geschaltet sind und zum Trennen des Stromkreises aus einem geschlossenen Zustand in einen Trennzustand überführt werden können, wobei keiner der Schalter/Schaltgruppen so ausgebildet ist, dass er alleine in der Lage ist, den Stromkreis dauerhaft zu trennen. Weiterhin weist die erfindungsgemäße Vorrichtung eine Steuereinheit auf, die den zweiten Schalter/Schaltgruppe ansteuert und die so ausgebildet ist, dass der zweite Schalter/Schaltgruppe zeitlich nach dem ersten Schalter/Schaltgruppe aus dem geschlossenen Zustand in den Trennzustand überführt wird. Die erfindungsgemäße Vorrichtung ist dadurch gekennzeichnet, dass der erste Schalter/Schaltgruppe ein Hochstrom-Hochspannungsschalter ist, der in seinem Inneren im Bereich des Trennelements, durch dessen Trennung der Stromkreis getrennt wird, ein Löschmittel aufweist, und dass die Steuereinheit so ausgebildet ist, dass der zweite Schalter/Schaltgruppe spätestens aus dem geschlossenen Zustand in den Trennzustand überführt wird, bevor eine in den zweiten Schalter/Schaltgruppe eingebrachte Energiemenge erreicht wird, die zu dessen Zerstörung führt.

Im Folgenden soll der Begriff "Schalter" für einen einzelnen Schalter, aber auch für eine Schaltgruppe stehen.

Auch sind hier Schalter/Schaltgruppen eingeschlossen, bei denen mehr als zwei Schalter bzw. Einzelbaugruppen nacheinander angesteuert werden. Das Schaltprinzip bzw. Schutzprinzip ist das gleiche, nur der Einfachheit halber werden hier stets nur zwei Schalter/Schaltgruppen beschrieben.

Bei dem Trennen des Stromkreises durch den ersten Schalter wird die in der Kreisinduktivität gespeicherte Energie in den ersten Schalter eingebracht. Diese Energie führt zu einem Lichtbogen zwischen den zwei aufgetrennten Enden eines Trennelements des Schalters. Dabei wird eine Menge an Energie in den ersten Schalter eingebracht, die dazu führen würde, dass der erste Schalter nach dem eigentlichen Trennvorgang wieder leitfähig oder zerstört würde. Durch das zeitversetzte Schalten des zweiten Schalters kann die Energiemenge, die in den ersten Schalter eingebracht wird, verringert werden, da ein Teil der abzubauenden Energie in den zweiten Schalter eingebracht wird, der zudem zusätzlich nur eine deutlich niedrigere Schaltbelastung bzgl. Strom und Spannung über dessen Verbindungselement im Augenblick von dessen Ansteuerung vorfindet bzw. verkraften muss. Auch wird dadurch ermöglicht, dass der Stromkreis unterbrochen wird, bevor sich durch den wieder leitfähig werdenden ersten Schalter erneut eine Kreisinduktivität aufbauen kann, die der zweite Schalter nicht verkraften würde. Jeder Schalter für sich alleine könnte die gesamte in der Kreisinduktivität gespeicherte Energie nicht verkraften, würde entweder zerstört oder wieder leitfähig werden und wäre somit nicht in der Lage, den Stromkreis dauerhaft und sicher zu trennen. Auf diese Weise können Stromkreise mit einer so hohen induktiven Last dauerhaft und sicher getrennt werden, für die ein Schalter alleine nicht ausreichen würde.

Eine Sonderform der Ansteuerung bzw. Schaltung der beiden Schalter/Schaltbaugruppen ist die gleichzeitige Ansteuerung der beiden Schalter. Damit würde man die über jeden der beiden Schalter abfallende Spannung halbieren, die in die einzelnen Schalter einfließenden Energien damit ebenfalls halbieren. Beide Schalter würden damit, eine baugleiche Ausführung der beiden Schalter vorausgesetzt, gleichartig belastet. Für kleinere Stromkreisinduktivitäten mag das noch in Ordnung sein, bei höheren Stromkreisinduktivitäten besteht jedoch die Gefahr, dass nach der Trennung beide Baugruppen wieder leitfähig werden, was überhaupt nicht zu akzeptieren wäre. Auch würde man damit die sehr hohe Trennfähigkeit der einzelnen Schalter nicht nutzen können, weil man ja hier bei beiden Schaltern den Isolationswiderstand nach der Trennung im Auge haben müsste, und könnte nicht den zweiten Schalter nur mit/bei extrem niedriger Schaltbelastung einsetzen.

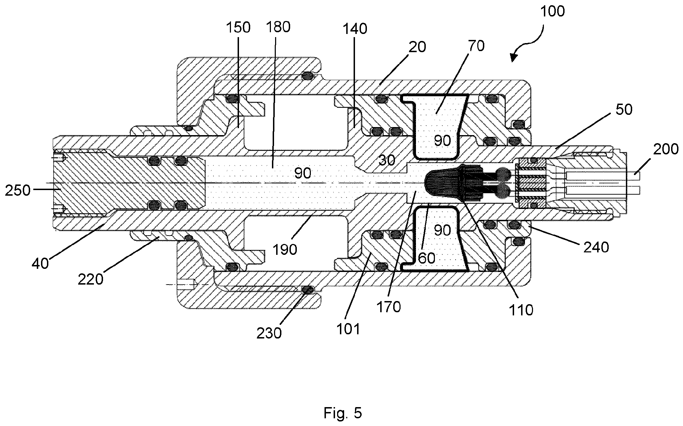

Auch könnte man nur bei einer zeitlich nacheinander gestaffelten Ansteuerung bzw. Trennungsvorgängen verschiedene Schaltertypen miteinander kombinieren. So kann beispielsweise ein Schalter mit hoher Trennfähigkeit bei hoher Spannung und hohem Strom im Augenblick seiner Ansteuerung wie die so genannte Powerfuse (siehe Figur 5) als erster Schalter eingesetzt werden, während ein herkömmlicher Batteriecutter, der nicht alleine einen hohen Strom bei hoher Spannung schalten könnte, als zweiter Schalter im Stromkreis eingesetzt werden kann, weil dieser ja zu diesem Zeitpunkt, also nach dem Trennvorgang des ersten Schalters, nur mehr eine niedrige Spannung bei einen niedrigen Strom trennen muss und hierbei auch kein Löschmittel verwenden muss.

Erfindungsgemäß wird als erster Schalter vorzugsweise einer verwendet, der ein Hochstrom-Hochspannungs-Schalter ist, d.h. in der Lage ist, Stromkreise mit hohen Strömen bei hohen Spannungen zuverlässig zu trennen. Solche Hochstrom-Hochspannungs-Schalter können in der Regel Stromkreise mit Strömen bis zu 30 kA und Spannungen bis zu 2000 V zuverlässig und dauerhaft trennen. Derartige Hochstrom-Hochspannungs-Schalter sind beispielsweise aus DE 10 2014 107 853 A1, DE 10 2014 110 825 A1, DE 20 2015 100 525 U1, DE 10 2015 112 141 A1, DE 10 2015 114 279 A1, DE 10 2015 114 894 A1, DE 10 2016 124 176 A1 und DE 10 2017 123 021 A1 bekannt. Ist der Schalter eine Schaltgruppe, dann umfasst diese vorzugsweise oder besteht vorzugsweise aus einer Parallelschaltung aus einer oder mehreren Schmelzsicherungen und einem herkömmlichen Batteriecutter. Dabei handelt es sich vorzugsweise um Batteriecutter, wie sie beispielsweise für die Batterie- bzw. Kabelschaltung herkömmlicher Fahrzeugbatterien bis 56 V bekannt sind. Beide genannten Systeme sind für die primäre Stromabschaltung bei hohen Schaltspannungen und hohen Schaltströmen geeignet. Der erste Schalter/Schaltgruppe weist in dem inneren im Bereich des Trennelements, durch dessen Trennung der Schaltkreis getrennt wird, ein Löschmittel auf. Durch das Löschmittel wird gewährleistet, dass eine höhere Energie im Moment des Trennens des Stromkreises von dem Schalter aufgenommen werden kann, da die Lichtbogenenergie dazu verwendet wird, das Löschmittel zu verdampfen und in seine Bestandteile zu zerlegen. Schalter ohne solche Löschmittel eignen sich nicht derart zum Trennen von Stromkreisen mit hohen Schaltspannungen bei hohen Schaltströmen. Der nachteilige Effekt der chemischen Umwandlung des Löschmittels in ein leitendes Material führt allerdings dazu - wie weiter oben genannt -, dass der Schalter ab einem bestimmten Energieeintrag nach dem eigentlichen Trennvorgang sehr schnell wieder elektrisch leitend wird.

Das Löschmittel kann ein festes, pulverförmiges oder ein flüssiges Medium sein. Vorzugsweise ist das Löschmittel ein verdampfbares Medium. Vorzugsweise ist das Löschmittel ein flüssiges oder gelförmiges Medium, das bei Erreichen der Siede- oder Verdampfungstemperatur ganz oder teilweise in einen gasförmigen Zustand übergeht. Gleichzeitig ist es bevorzugt, dass das Löschmittel auch elektrisch isolierende Eigenschaften hat, damit der Lichtbogen nach ausreichender Entfernung der beiden aufgetrennten Teile des Trennbereichs gelöscht werden kann und danach zwischen den getrennten Kontakten eine ausreichende Isolation gegen einen hier dann unerwünschten Stromfluss besteht. Vorzugsweise ist das Löschmittel ein Öl, beispielsweise Silikonöl mit oder ohne Verdickungsmittel, oder ein Silan bzw. Polysiloxan, beispielsweise Hexasilan oder Pentasilan mit möglichst wenig oder noch besser ohne Kohlenstoffatomanteil.

Als zweiter Schalter kann erfindungsgemäß einer verwendet werden, der nur einen geringeren Energieeintrag verkraftet als der erste Schalter, da ein Großteil der Energie aus der Kreisinduktivität bereits im ersten Schalter vernichtet wurde. Vorzugsweise ist der zweite Schalter einer, der in der Lage ist, Stromkreise mit Strömen bis zu 100 A bei Spannungen im Augenblick der Ansteuerung bis zu 100 V zuverlässig und dauerhaft trennen und nach dessen Trennung Spannungen bis zu 1000 V oder 2000 V ohne Durchbruch isolieren zu können. Da die hohe Energie des Lichtbogens im ersten Schalter wieder schnell zu seiner Leitfähigkeit führt, ist der zweite Schalter vorzugsweise so ausgebildet, dass seine Schaltverzögerung im Bereich von 1 ms bis 10 ms liegt.

Unter Schaltverzögerung versteht man hierbei den zeitlichen Abstand, in dem der erste und der zweite Schalter den Stromkreis trennen bzw. vom geschlossenen Zustand in den Trennzustand überführt werden. Denkbar wäre jedoch auch ein zweiter Schalter mit einer größeren Schaltverzögerung, wenn beispielsweise die Auslösung des zweiten Schalters bereits erfolgt, bevor ein Lichtbogen im zweiten Schalter entsteht, aber beispielsweise erst kurz danach von dem geschlossenen Zustand in den Trennzustand übergeht. Letzteres ist jedoch nur möglich, wenn das für die sichere und dauerhafte Trennung des Stromkreises benötigte Zeitintervall zwischen dem Schalten des ersten und des zweiten Schalters aufgrund sämtlicher Kenngrößen des Stromkreises vorab festgelegt werden kann. Als zweiten Schalter können ebenso die Systeme verwendet werden, die oben für den ersten Schalter genannt sind. Weiterhin kann aber auch ein herkömmlicher Batteriecutter ohne eine parallel geschaltete Schmelzsicherung eingesetzt werden, da diese Batteriecutter im nicht getriggerten Zustand die hohen auftretenden Trennströme zwar nicht schalten, aber sehr gut leiten können. Weiterhin muss der zweite Schalter nach der Stromabschaltung durch den ersten Schalter nur einen Strom im Bereich von 0 A bis 100 A bei einer Schaltspannung über den Schaltkontakten des zweiten Schalters von unter 100 V schalten können. Relais oder elektromagnetische Schütze eignen sich eher nicht als zweiter Schalter, weil die für die üblichen Betriebsströme von 400 A bis 1000 A verwendeten Relais oder Schütze im Automotivebereich bei den hohen, beispielsweise von Lithiumionenbatterien lieferbaren Strömen von über 10 kA bereits zwischen 0,5 ms und 2 ms explodieren (die riesigen und schweren Schütze, die hierfür bei Eisenbahnzugmaschinen verwendet werden, werden hier nicht beachtet, weil sie im Automotivebereich, wie auch bei Elektroflugzeugen aus Gewichts-, Abmessungs- und Kostengründen in keinem Fall eingesetzt werden können).

Der erfindungsgemäß verwendbare Hochstrom-Hochspannungsschalter oder Batteriecutter weist vorzugsweise ein Gehäuse auf, das eine den Strompfad durch den Hochstrom-Hochspannungsschalter oder Batteriecutter definierende Kontakteinheit / ein Verbindungselement umgreift, die einen ersten und zweiten Anschlusskontakt und einen Trennbereich aufweist. Die Kontakteinheit ist vorzugsweise so ausgebildet, dass ihr über den ersten Anschlusskontakt ein Strom zuführbar und von ihr über den zweiten Anschlusskontakt abführbar ist, oder umgekehrt. Der Trennbereich ist vorzugsweise so ausgebildet, dass, wenn er getrennt wird, der Strompfad zwischen dem ersten Anschlusskontakt und dem zweiten Anschlusskontakt unterbrochen ist. Der Trennbereich ist vorzugsweise innerhalb einer Reaktionskammer angeordnet. Die Reaktionskammer ist mit einem Löschmittel gefüllt. Ist der Schalter ein Hochstrom-Hochspannungsschalter, kann die Kontakteinheit einen Treibspiegel aufweisen oder mit einem Treibspiegel oder einem Kolben in Verbindung stehen, der so ausgebildet ist, dass er durch einen beaufschlagenden Druck von einer Ausgangposition in eine Endposition bewegbar ist, wobei in der Endposition des Treibspiegels der Trennbereich getrennt und ein Isolationsabstand zwischen dem ersten und dem zweiten Anschlusskontakt erreicht ist.

Durch die beschriebene Anordnung der Serienschaltung des ersten und des zweiten Schalters können Stromkreise mit deutlich größerer Kreisinduktivität abgeschaltet werden, als das nur mit einem einzigen Schalter möglich wäre. Der erste Schalter übernimmt hier dissipativ den Hauptanteil der in der Kreisinduktivität im Augenblick der Trennung gespeicherten magnetischen Energie, während der zweite Schalter nur noch einen sehr kleinen Teil der bei dessen Entwicklung eventuell noch in der Kreisinduktivität vorhandenen magnetischen Energie übernehmen muss. Deshalb muss der zweite Schalter nicht zwingend einer sein, der ein Löschmittel in der Umgebung seines Trennelements aufweist. Handelt es sich jedoch um Stromkreise mit extrem hohen Kreisinduktivitäten, so sollte aus Sicherheitsgründen der zweite Schalter ebenso einer sein, der ein Löschmittel in der Umgebung seines Trennelements aufweist. Hierfür mögliche Löschmittel sind weiter oben genannt.

Bei den erfindungsgemäß zu verwendenden Schaltern kann im Sinne der vorliegenden Erfindung von adiabaten Systemen ausgegangen werden, da die Schaltvorgänge so schnell sind, dass ein Wärmeaustausch mit der Umgebung zumindest während des Trennvorgangs vernachlässigbar ist.

Die Eigenschaft, dass der erste und der zweite Schalter nicht so ausgebildet sind, dass sie alleine in der Lage sind, den Stromkreis dauerhaft und sicher zu trennen, ist darauf zurückzuführen, dass bekannte Hochstrom-Hochspannungs-Schalter bei sehr hohen Schaltspannungen und sehr hohen Schaltströmen nach dem eigentlichen Trennvorgang wieder leitfähig werden. Unter einer dauerhaften und sicheren Trennung des Stromkreises versteht man erfindungsgemäß, dass der/die Schalter dauerhaft isoliert/isolieren und somit nicht wieder leitfähig werden.

Die erfindungsgemäße Vorrichtung ist sowohl für AC-, wie auch für DC-Stromkreise verwendbar. So hat man zwar bei AC-Stromkreisen stets einen Nulldurchgang des Stroms, es kann aber nie vorhergesagt werden, wann der Stromkreis abgeschaltet werden soll. Muss im Strommaximum geschaltet werden, liegt quasi der DC-Stromabschaltzustand vor.

Das Trennelement in den Schaltern kann hohlzylindrisch oder in der Form eines länglichen Hohlkörpers mit einer von einem Kreis abweichenden Querschnittsgrundfläche sein, sodass es durch einen inneren Druck zerrissen wird, kann aber auch für die sogenannten Batteriecutter als stabförmiger massiver Leiter ausgebildet sein, der an einer oder mehreren Stellen durch einen Kolben oder ein Geschoss aufgebrochen wird. In beiden Fällen werden meist Materialien und meist auch Löschmittel verwendet, die bei bzw. nach Lichtbogenberührung bei entsprechend großer Energieeinwirkung elektrisch leitfähig werden können.

In einer Ausgestaltung der erfindungsgemäßen Vorrichtung ist die Steuereinheit vorzugsweise so ausgebildet, dass der zweite Schalter frühestens dann aus dem geschlossenen Zustand in den Trennzustand überführt wird, wenn im ersten Schalter so viel Energie aufgenommen wurde, dass die verbleibende Energiemenge, die in den zweiten Schalter eingebracht wird, nicht zur Zerstörung des zweiten Schalters führt.

Bei der erfindungsgemäßen Vorrichtung ist die Steuereinheit so ausgebildet, dass der zweite Schalter spätestens aus dem geschlossenen Zustand in den Trennzustand überführt wird, bevor eine in den zweiten Schalter eingebrachte Energiemenge erreicht wird, die zu dessen Zerstörung führt.

Unter der Zerstörung des Schalters wird erfindungsgemäß verstanden, dass durch die eingebrachte Energie und das Entstehen des Lichtbogens das Schaltergehäuse aufbricht oder der Schalter explodiert.

In einer Ausgestaltung der erfindungsgemäßen Vorrichtung sind der erste und der zweite Schalter vorzugsweise aktiv durch einen ansteuerbaren Antrieb aus dem geschlossenen Zustand in den Trennzustand überführbar. Unter "aktiv" wird jegliche Art von mechanischer oder pyrotechnischer Energie verstanden, die den Trennbereich (Trennelement) eines Schalters kommandiert trennen kann. So kann beispielsweise der Trennbereich durch eine einwirkende Zug- oder Druckbewegung getrennt werden. Oder es wird ein pyrotechnisches Material, wie beispielsweise ein Anzünder (EED) oder ein Minidetonator, verwendet, der sich entweder in einer Reaktionskammer befindet, oder aber außerhalb der Reaktionskammer so angebracht ist, dass er durch Zug- oder Druckbewegung oder eine Stoßwelle auf den Trennbereich wirken kann und dessen Trennung verursacht.

In einer Ausgestaltung der erfindungsgemäßen Vorrichtung ist der erste Schalter passiv bei Überschreiten einer bestimmten Schwellstromstärke des Stroms aus dem geschlossenen Zustand in den Trennzustand überführbar, und der zweite Schalter ist aktiv durch einen ansteuerbaren Antrieb aus dem geschlossenen Zustand in den Trennzustand überführbar. Diese passive Auslösung kann bspw. durch Schmelzen des den Trennbereich bildenden Materials, beispielsweise beim Erreichen eines bestimmten Stromintegrals, erfolgen. Auch kann die passive Auslösung durch die Wirkung von pyrotechnischen Zünd- und Anzündstoffen, wie auch nur durch thermische Einwirkung sich zerlegender Stoffe, wie bspw. Tetrazen unterstützt werden. Dabei können auch Vorrichtungen an einem oder an beiden aufgetrennten Teilen des Trennbereichs angebracht sein, die diese beiden Enden weiter voneinander entfernen, bspw. durch eine existierende Zugbelastung, die nach Trennen des Trennbereichs wirken kann. Beispielhaft kann hier eine Zugbelastung durch eine vorgespannte Feder genannt werden.

In einer Ausgestaltung der erfindungsgemäßen Vorrichtung ist die Steuereinheit vorzugsweise so ausgebildet, dass sie in Abhängigkeit eines bestimmten gemessenen Stroms oder einer bestimmten gemessenen Spannung, der/die am ersten Schalter anliegt, den zweiten Schalter von dem geschlossenen Zustand in den Trennzustand überführt.

In einer Ausgestaltung der erfindungsgemäßen Vorrichtung ist die Steuereinheit vorzugsweise so ausgebildet, dass der zweite Schalter von dem geschlossenen Zustand in den Trennzustand überführt wird, wenn der durch beide Schalter fließende Strom auf einen Wert im Bereich von 25% bis 40% des bei Trennbeginn des ersten Schalters vorhandenen Stroms gefallen ist.

In einer Ausgestaltung der erfindungsgemäßen Vorrichtung ist die Steuereinheit vorzugsweise so ausgebildet, dass der zweite Schalter von dem geschlossenen Zustand in den Trennzustand überführt wird, wenn der durch beide Schalter fließende Strom auf einen Wert im Bereich von 5% bis 15% des bei Trennbeginn des ersten Schalters vorhandenen Stroms gefallen ist.

In einer Ausgestaltung der erfindungsgemäßen Vorrichtung ist die Steuereinheit vorzugsweise so ausgebildet, dass sie in Abhängigkeit eines bestimmten gemessenen Stromabfalls im Stromkreis den zweiten Schalter von dem geschlossenen Zustand in den Trennzustand überführt.

Die vorliegende Erfindung betrifft auch einen Stromkreis, der neben einer erfindungsgemäßen Vorrichtung auch eine Spannungsquelle und eine induktive Last aufweist. Neben der induktiven Last kann im Stromkreis auch ein Lastwiderstand vorhanden sein. Alle bevorzugten Ausführungsformen oder Ausgestaltungen der erfindungsgemäßen Vorrichtung gelten auch für den erfindungsgemäßen Stromkreis.

Die vorliegende Erfindung betrifft auch ein Verfahren zum Trennen eines Stromkreises mit induktiver Last mit einem ersten und einem zweiten Schalter, die in Reihe zueinander geschaltet sind und zum Trennen des Stromkreises aus einem geschlossenen Zustand in einen Trennzustand überführt werden, wobei keiner der Schalter so ausgebildet ist, dass er alleine in der Lage ist, den Stromkreis dauerhaft zu trennen, wobei der zweite Schalter zeitlich nach dem ersten Schalter aus dem geschlossenen Zustand in den Trennzustand überführt wird. Das erfindungsgemäße Vorfahren ist dadurch gekennzeichnet, dass der erste Schalter/Schaltgruppe ein Hochstrom-Hochspannungsschalter ist, der in seinem Inneren im Bereich des Trennelements, durch dessen Trennung der Stromkreis getrennt wird, ein Löschmittel aufweist, und dass die Steuereinheit so ausgebildet ist, dass der zweite Schalter/Schaltgruppe spätestens aus dem geschlossenen Zustand in den Trennzustand überführt wird, bevor eine in den zweiten Schalter/Schaltgruppe eingebrachte Energiemenge erreicht wird, die zu dessen Zerstörung führt.

In einer Ausgestaltung des erfindungsgemäßen Verfahrens ist es bevorzugt, dass der zweite Schalter frühestens dann aus dem geschlossenen Zustand in den Trennzustand überführt wird, wenn im ersten Schalter so viel Energie aufgenommen wurde, dass die verbleibende Energiemenge, die in den zweiten Schalter eingebracht wird, nicht zu dessen Zerstörung führt.

In einer Ausgestaltung des erfindungsgemäßen Verfahrens ist es bevorzugt, dass der erste und der zweite Schalter aktiv durch einen ansteuerbaren Antrieb aus dem geschlossenen Zustand in den Trennzustand überführt werden.

In einer Ausgestaltung des erfindungsgemäßen Verfahrens ist es bevorzugt, dass der erste Schalter passiv bei Überschreiten eines bestimmten Nennwertes aus dem geschlossenen Zustand in den Trennzustand überführt wird, und der zweite Schalter aktiv durch einen ansteuerbaren Antrieb aus dem geschlossenen Zustand in den Trennzustand überführt wird. Hierfür ist der ansteuerbare Antrieb vorzugsweise mit einer Steuereinheit verbunden, die den Antrieb ansteuert und auf diese Weise den zweiten Schalter aus dem geschlossenen Zustand in den Trennzustand überführen kann.

In einer Ausgestaltung des erfindungsgemäßen Verfahrens ist es bevorzugt, dass der zweite Schalter in Abhängigkeit eines bestimmten gemessenen Stroms oder einer bestimmten gemessenen Spannung durch den ersten Schalter von dem geschlossenen Zustand in den Trennzustand überführt wird.

In einer Ausgestaltung des erfindungsgemäßen Verfahrens ist es bevorzugt, dass der zweite Schalter von dem geschlossenen Zustand in den Trennzustand überführt wird, wenn der durch beide Schalter fließende Strom auf einen Wert im Bereich von 25% bis 40% des bei Trennbeginn des ersten Schalters vorhandenen Stroms gefallen ist.

In einer Ausgestaltung des erfindungsgemäßen Verfahrens ist die Steuereinheit vorzugsweise so ausgebildet, dass der zweite Schalter von dem geschlossenen Zustand in den Trennzustand überführt wird, wenn der durch beide Schalter fließende Strom auf einen Wert im Bereich von 5% bis 15% des bei Trennbeginn des ersten Schalters vorhandenen Stroms gefallen ist.

In einer Ausgestaltung des erfindungsgemäßen Verfahrens ist die Steuereinheit vorzugsweise so ausgebildet, dass sie in Abhängigkeit eines bestimmten gemessenen Stromabfalls im Stromkreis den zweiten Schalter von dem geschlossenen Zustand in den Trennzustand überführt.

In dem erfindungsgemäßen Verfahren kommt vorzugsweise eine erfindungsgemäße Vorrichtung oder ein erfindungsgemäßer Stromkreis zum Einsatz. Somit sollen auch alle bevorzugten Ausführungsformen und Ausgestaltungen, die in Verbindung mit der erfindungsgemäßen Vorrichtung weiter oben genannt sind, für das erfindungsgemäße Verfahren gelten. Für das Überführen des zweiten Schalters von dem geschlossenen in den Trennzustand wird vorzugsweise ebenso eine wie weiter oben genannte Steuereinheit verwendet. Gleiches gilt auch für den zweiten Schalter, sofern dieser von der Steuereinheit angesteuert wird.

Die vorliegende Erfindung wird nun anhand der folgenden Figuren genauer erläutert. Diese haben jedoch nur exemplarischen Charakter und sollen die vorliegende Erfindung beispielhaft erläutern.
- Fig. 1:: Figur 1 zeigt einen erfindungsgemäßen Stromkreis mit einer erfindungsgemäßen Vorrichtung.
- Fig. 2:: Figur 2 zeigt den zeitlichen Spannungsverlauf der Kondensatorbank, den Spannungsverlauf über den ersten Schalter, sowie den Stromverlauf im gesamten Stromkreis kurz vor und nach dem Schalten des ersten Schalters in einem Stromkreis nach Figur 1.
- Fig. 3:: Figur 3 zeigt den zeitlichen Verlauf des Stroms durch den ersten und den zweiten Schalter, die in Reihe in einem Stromkreis nach Figur 1 geschaltet sind.
- Fig. 4a:: Figur 4a zeigt beispielhaft einen Batteriecutter im geschlossenen Zustand, wie er als zweiter Schalter oder in Verbindung mit einer parallel geschalteten Schmelzsicherung als Teil einer ersten Schaltgruppe eingesetzt werden kann.
- Fig. 4b:: Figur 4b zeigt den Batteriecutter der Fig. 4a im Trennzustand.
- Fig. 5:: Figur 5 zeigt beispielhaft einen Hochstrom-Hochspannungsschalter, wie er als erster oder zweiter Schalter eingesetzt werden kann.

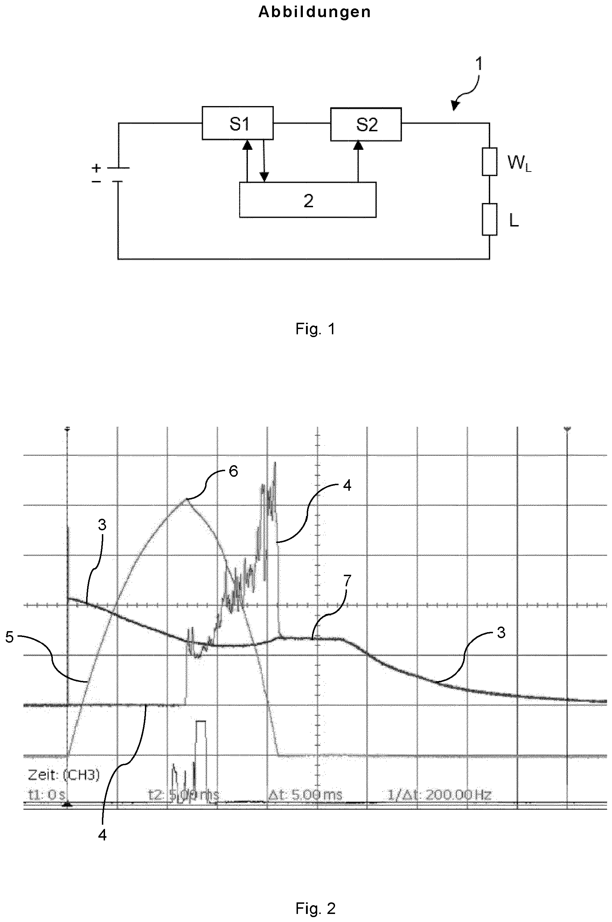

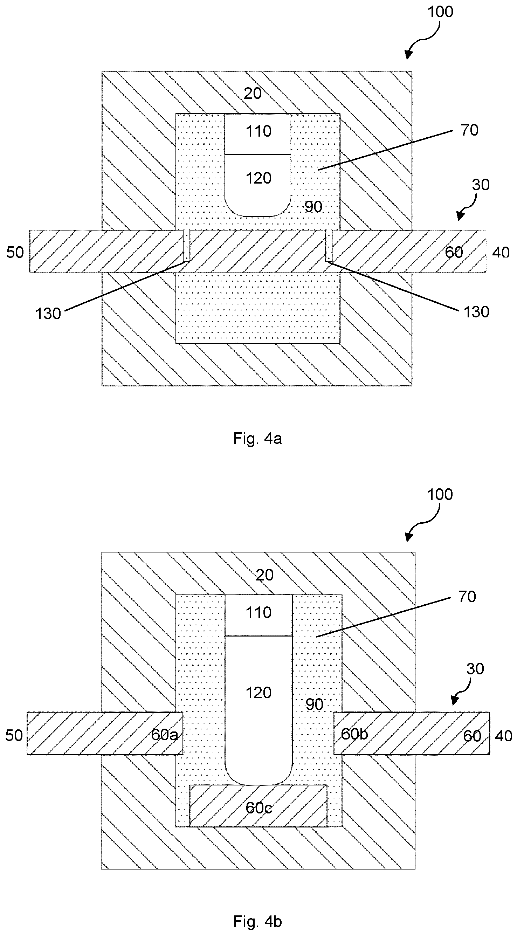

Fig. 1 zeigt einen erfindungsgemäßen Stromkreis 1 mit einer erfindungsgemäßen Vorrichtung (erster Schalter S1, zweiter Schalter S2 und Steuereinheit 2). Der Stromkreis 1 umfasst eine Spannungsquelle, die mit + und - gekennzeichnet ist, einen ersten Schalter S1 und einen zweiten Schalter S2, die in Reihe zueinander geschaltet sind, sowie eine induktive Last L und einen Lastwiderstand W_{L}. Weiterhin ist auch eine Steuereinheit 2 vorgesehen, die beispielsweise den Stromverlauf durch den ersten Schalter S1 auswertet und in Abhängigkeit davon ein Zündsignal an den zweiten Schalter S2 erzeugt. Auf diese Weise kann der zweite Schalter S2 von dem geschlossenen Zustand in den Trennzustand überführt werden, in der der zweite Schalter S2 den Stromkreis 1 unterbricht. Der erste Schalter S1 kann aktiv durch ein Zündsignal von der Steuereinheit 2 ausgelöst werden, kann aber auch passiv durch Überschreiten einer bestimmten Schwellstromstärke geschaltet werden. Die Steuereinheit 2 ist so ausgebildet, dass sie den zweiten Schalter S2 erst schaltet, wenn genügend Energie, die in der induktiven Last L gespeichert ist, nach dem Schalten des ersten Schalters S1 in diesem vernichtet wurde. Auf diese Weise wird gewährleistet, dass die Energie, die in der induktiven Last L gespeichert ist, im Falle des Schaltens auf die beiden Schalter S1 und S2 aufgeteilt wird, sodass selbst im Falle des Wiederleitfähig-Werdens des ersten Schalters S1 aus den einleitend genannten Gründen ein dauerhaftes und sicheres Trennen des Stromkreises möglich ist. Die Steuereinheit 2 kann für die Auswertung des Stromverlaufs und das Erzeugen eines Zündsignals für den zweiten Schalter S2 einen Komparator/Zündelektronik aufweisen. Der erste Schalter S1 kann ein Hochstrom-Hochspannungsschalter sein, wie er in Fig. 5 gezeigt ist. Er kann aber auch ein Batteriecutter sein, wie er in den Fig. 4a und 4b gezeigt ist, zu dem parallel eine Schmelzsicherung geschaltet ist. Der zweite Schalter S2 kann ebenso ein Hochstrom-Hochspannungsschalter sein, wie er in Fig. 5 gezeigt ist, er kann aber auch ein Batteriecutter sein, wie er in den Fig. 4a und 4b gezeigt ist, ohne dass notwendigerweise eine Schmelzsicherung parallel dazu geschaltet ist. Ist der erste Schalter S1 ein Hochstrom-Hochspannungsschalter, so kann der zweite Schalter S2 sowohl ein Hochstrom-Hochspannungsschalter als auch ein Batteriecutter sein. Ist der erste Schalter S1 eine Parallelschaltung aus Batteriecutter und Schmelzsicherung, so ist es bevorzugt, dass der zweite Schalter ein Batteriecutter ist. Der Grund hierfür liegt darin, dass der zweite Schalter in der Regel weniger Energie aufnehmen können muss als der erste Schalter, und aus Kostengründen dann auch ein günstigerer zweiter Schalter genommen wird.

Fig. 2 zeigt den zeitlichen Spannungsverlauf 3 der Kondensatorbank, den Spannungsverlauf 4 über die Anschlusskontakte des ersten Schalters, sowie den Stromverlauf 5 des gesamten Stromkreises kurz vor und nach dem Schalten des ersten Schalters in einem Stromkreis nach Fig. 1. Hierzu wurde als erster Schalter ein Hochstrom-Hochspannungsschalter, wie in Fig. 5 gezeigt, eingesetzt. Die Kurve 3 zeigt den Spannungsverlauf der Kondensatorbank. Die Kondensatorbank weist eine anfängliche Spannung von 1200 V auf, die während des Stromflusses auf 650V im Augenblick des Trennbeginns des Schalters abfällt. Die Kurve 4 zeigt den Spannungsverlauf über die Stromanschlüsse des ersten Schalters. Die Kurve 5 zeigt den Stromverlauf des gesamten Stromkreises. Der Zeitpunkt 6 ist der Zeitpunkt des Öffnens des ersten Schalters mit den hier dann herrschenden Trennbedingungen von 650 V und 31 kA. Bis zum Zeitpunkt 6 des Öffnens des ersten Schalters nimmt im gesamten Stromkreis der Strom zu (Stromverlauf 5). Nach dem Trennbeginn in 6 nimmt der Strom im gesamten Stromkreis drastisch ab. In der Kurve 4 (Spannungsverlauf über den ersten Schalter) ist nach dessen Trennbeginn eine große Spannungszunahme erkennbar, die weit über die Spannung im Augenblick des Trennbeginns, ja sogar weit über die Ladespannung der Kondensatorbank hinausgeht. Dies ist dem Magnetfeld der Kreisinduktivität geschuldet, dessen Zusammenbrechen nach dem Zeitpunkt des Trennbeginns durch eine hier entstehende induzierte Spannung bzw. einen hier induzierten Strom verhindert werden soll (Lenzsche Regel), dessen Richtung die gleiche ist wie der Strom im Stromkreis vor Trennbeginn. Bei Trennende, also bei Strom im Stromkreis gleich 0 A, ist die Spannung über den ersten Schalter (Kurve 4) wieder gleich der Spannung der nun vom Stromkreis getrennten Kondensatorbank. Mit Trennende beginnt das Isolationsplateau 7. Zu diesem Zeitpunkt isoliert der erste Schalter vollständig. Dies ist daran zu sehen, dass die Spannung der Kondensatorbank (Kurve 3) gleich der Spannung über den Schalterkontakten ist (Kurve 4), während das Isolationsplateau 7 nicht weiter abnimmt. Es ist allerdings auch zu erkennen, dass der erste Schalter nach einer gewissen Zeit wieder leitfähig wird, da das Isolationsplateau 7 nicht dauerhaft gehalten wird, sondern der Spannungsverlauf der Kondensatorbank 3 nach dem Isolationsplateau 7 wieder weiter nach unten geht, d.h. hier kommt es zu einer weiteren Entladung der Kondensatorbank. Es ist somit eindeutig gezeigt, dass der Hochstrom-Hochspannungsschalter, wie in Fig. 5 gezeigt, nach einer gewissen Zeit des Trennens des Stromkreises wieder leitfähig wird. Der Entladestrom ist hierbei mit ca. 10 A eher sehr klein, was in der Stromkurve 5 wegen des hier sehr großen Strommaßstabes nicht mehr zu erkennen ist.

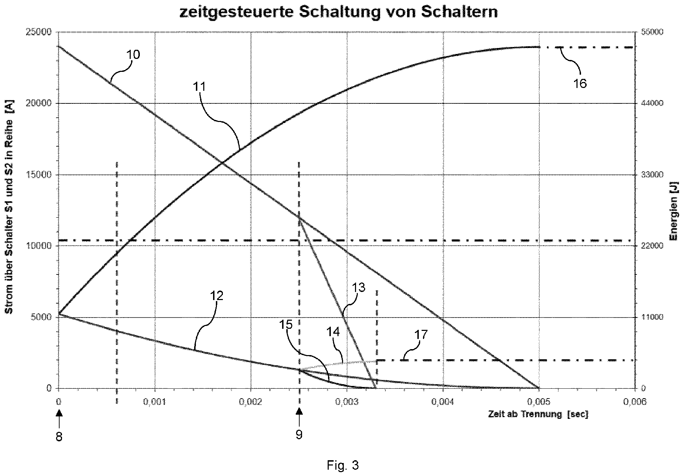

Fig. 3 zeigt schematisch den linearisierten zeitlichen Stromverlauf 10 über den ersten und den zweiten Schalter, die in Reihe in einem Stromkreis nach Fig. 1 geschaltet sind. Der Schaltzeitpunkt 8 des ersten Schalters liegt bei 0 Sekunden. Die Kurve 10 gibt den abnehmenden Stromverlauf über den ersten und den zweiten Schalter an. Die Kurve 11 zeigt den Energieeintrag in den ersten Schalter nach dem Schalten des ersten Schalters. Der Energieverlauf 11 verläuft so lange nach der angegebenen Kurve, bis der zweite Schalter bei 9 geschaltet wird. Wenn es keinen zweiten Schalter gäbe, würde die maximale Energieaufnahme bei 16 des ersten Schalters enden, was weit über der Belastbarkeit des Schalters 1 von 11000 A liegen würde (siehe strichlierte Linie). Die Kurve 12 zeigt die Energieabnahme in der induktiven Last nach dem Schalten des ersten Schalters.

Wird zum Zeitpunkt 9 der zweite Schalter geschaltet, wird der Stromverlauf über den ersten und den zweiten Schalter wegen der viel geringeren Belastung des zweiten Schalters zum Zeitpunkt seines Trennbeginns schneller abnehmen, was an der Kurve 13 zu sehen ist. Ebenso erfolgt auch eine schnellere Energieabnahme 15 in der induktiven Last nach dem Schalten des zweiten Schalters. Die Kurve 14 zeigt den Energieverlauf über den zweiten Schalter nach dem Schalten des zweiten Schalters, d.h. zeigt die Energie, die im zweiten Schalter aufgenommen wird. Die maximale Energieaufnahme des zweiten Schalters ist mit dem sehr kleinen Niveau 17 erreicht, der zweite Schalter wird daher mit großer Reserve den Stromkreis sicher und dauerhaft trennen können, während der erste Schalter später leicht leitfähig werden wird, weil er über seine Grenze bei 11 kA belastet wurde.

Fig. 4a und Fig. 4b zeigen schematische Ansichten eines Batteriecutters 100 vor und nach der Trennung des Trennbereichs 60. Der Batteriecutter 100 weist ein Gehäuse 20 auf, durch das die Kontakteinheit 30 hindurchgeht. Die Kontakteinheit 30 weist auf der einen Seite einen ersten Anschlusskontakt 40 und auf der anderen Seite einen zweiten Anschlusskontakt 50 auf, die über den Trennbereich 60 im Batteriecutter 100 in Fig. 4a miteinander elektrisch in Verbindung stehen. Der Trennbereich 60 läuft durch eine Reaktionskammer 70, die von dem Gehäuse 20 umschlossen wird. Wie in der Fig. 4a gezeigt, kann der Trennbereich 60 zwei Sollbruchstellen 130 aufweisen, kann aber auch nur eine oder mehr als zwei Sollbruchstellen aufweisen. Die Reaktionskammer 70 ist vorzugsweise mit einem Löschmittel 90 gefüllt. Weiterhin ist in der Reaktionskammer 70 ein ansteuerbarer Antrieb 110 vorgesehen, der mit einem Stößel 120 in Verbindung steht. Der ansteuerbare Antrieb kann von der Steuereinheit angesteuert werden. Der Antrieb 110 kann beispielsweise als pyrotechnischer Antrieb ausgestaltet sein. Wird der Antrieb 110 betätigt, so beaufschlagt der Stößel 120 den Trennbereich 60 der Kontakteinheit 30 mit Druck. Hierbei kommt es zu einer Trennung des Trennbereiches 60 an den Sollbruchstellen 130, wodurch der erste Anschlusskontakt 40 und der zweite Anschlusskontakt 50 nicht mehr in Verbindung stehen. Fig. 4a zeigt den Batteriecutter 100 in der leitenden Stellung, wohingegen die Fig. 4b den gleichen Batteriecutter 100 nach dessen Schalten in der nicht-leitenden Stellung zeigt, in der der Trennbereich 6 in die getrennten Teile 6a, 6b und 6c getrennt ist. Über den Abstand von Stößel 120 zur Kontakteinheit 30 kann die Impulskraft eingestellt werden, die zusätzlich zur hydraulischen Kraft aus dem Produkt Druck im Antrieb 110 x die bedrückte Fläche des Stößels 120 für das Aufreißen der Kontakteinheit zur Verfügung steht.

Fig. 5 zeigt einen Hochstrom-Hochspannungsschalter 100, der ein Gehäuse 20 umfasst, in dem eine Kontakteinheit 30 angeordnet ist. Das Gehäuse 20 ist so ausgebildet, dass es einem innerhalb des Gehäuses 20 erzeugten Druck, der beispielsweise bei einer pyrotechnischen Auslösung des Hochstrom-Hochspannungsschalters 100 erzeugt wird, standhält, ohne dass die Gefahr einer Beschädigung oder gar eines Aufplatzens besteht. Die Kontakteinheit 30 ist im dargestellten Ausführungsbeispiel als ein durch den Treibspiegel 101 im Stauchbereich bedrücktes Schaltrohr ausgebildet, so dass es im Trennbereich 60 und dem Stauchbereich 190 als Rohr ausgebildet ist. Die Kontakteinheit 30 besitzt im dargestellten Ausführungsbeispiel einen ersten Anschlusskontakt 40 mit einem größeren Durchmesser und einen zweiten Anschlusskontakt 50 mit einem geringeren Durchmesser. An den ersten Anschlusskontakt 40 schließt sich ein sich radial nach außen erstreckender Flansch 150 an, der sich an einem ringförmigen Isolatorelement 220, das aus einem isolierenden Material, beispielsweise einem Kunststoff, besteht, derart abstützt, dass die Kontakteinheit 30 nicht in axialer Richtung aus dem Gehäuse 20 heraus bewegt werden kann. Das Isolatorelement 220 weist hierzu eine ringförmige Schulter auf, an der sich der Flansch 150 der Kontakteinheit 30 abstützt. Zusätzlich isoliert das Isolatorelement 220 das Gehäuse 20 gegenüber der Kontakteinheit 30. Die Kontakteinheit 30 weist einen sich an den Flansch 150 in der Achse der Kontakteinheit 30 anschließenden Stauchbereich 190 auf. Die Wandstärke der Kontakteinheit ist im Stauchbereich 190, der eine vorbestimmte axiale Ausdehnung aufweist, so gewählt und auf das Material abgestimmt, dass sich bei einem Auslösen des Hochstrom-Hochspannungsschalters 100 infolge einer plastischen Deformation der Kontakteinheit 30 im Stauchbereich 190 eine Verkürzung des Stauchbereichs in axialer Richtung um eine vorbestimmte Wegstrecke ergibt, wodurch die nach dem Trennvorgang vorhandene Trennstrecke deutlich erhöht wird und sich hier additiv aus der Stauchstrecke und der Länge des Trennbereichs 60 ergibt.

An den Stauchbereich 190 schließt sich in axialer Richtung der Kontakteinheit 30 ein Flansch 140 an, auf dem im dargestellten Ausführungsbeispiel ein Treibspiegel 101 sitzt. Der Treibspiegel 101 umgreift die Kontakteinheit 30 derart, dass zwischen dem Außenumfang des Flanschs 140 und der Innenwandung des Gehäuses 20 ein isolierender Bereich des Treibspiegels 101 eingreift. Wirkt ein Druck auf die Fläche des Treibspiegels 101 ein, wird eine Kraft erzeugt, die über den Flansch 140 den Stauchbereich 190 der Kontakteinheit 30 zusammenpresst. Diese Kraft wird so gewählt, dass sich während des Auslösevorgangs des Hochstrom-Hochspannungsschalters 100 ein Stauchen des Stauchbereichs 190 ergibt, wobei der Treibspiegel 101 aus seiner Ausgangslage (Status vor der Auslösung des Hochstrom-Hochspannungsschalters 100) in eine Endposition (nach Beendigung des Schaltvorgangs) bewegt wird.

An den Treibspiegel 101 bzw. den Flansch 140 der Kontakteinheit 30 schließt sich ein Trennbereich 60 an. Auf dieser Seite der Kontakteinheit 30 schließt sich dann der zweite Anschlusskontakt 50 an. Ein Verschluss 240 verschließt das Gehäuse 20.

Im dargestellten Ausführungsbeispiel wird der Treibspiegel 101 bei der Montage des Hochstrom-Hochspannungsschalters 100 von der Seite des Anschlusskontakts 50 her auf die Kontakteinheit 30 aufgeschoben. Der Verschluss 240 ist als ein ringförmiges Bauteil gestaltet, das einen Außendurchmesser besitzt, der im Wesentlichen dem Innendurchmesser des Gehäuses 20 entspricht.

In dem axialen Ende der Kontakteinheit 30 im Bereich des zweiten Anschlusskontakts 50 ist ein Antrieb 110, vorzugsweise ein pyrotechnischer Antrieb vorgesehen. Durch einen Durchbruch des ringförmigen Verschlusses 240 können die elektrischen Anschlussleitungen 200 des Antriebs 110 nach außen geführt werden.

Der Trennbereich 60 ist so dimensioniert, dass er durch den erzeugten Gasdruck oder die erzeugte Stoßwelle des Antriebs 110 zumindest teilweise aufreißt, so dass sich der Druck bzw. die Stoßwelle auch aus der Brennkammer 170 in die als umgebender Ringraum ausgestaltete Reaktionskammer 70 ausbreiten kann.

Bei einer Aktivierung des Hochstrom-Hochspannungsschalters 100 mittels des Antriebs 110 wird also ein Druck oder eine Stoßwelle an der dem Stauchbereich 190 abgewandten Seite des Treibspiegels 101 erzeugt, wodurch der Treibspiegel 101 mit einer entsprechenden Axialkraft beaufschlagt wird. Diese Kraft wird durch eine geeignete Dimensionierung des pyrotechnischen Materials so gewählt, dass die Kontakteinheit 30 im Stauchbereich 190 plastisch deformiert, aufgerissen oder eingedrückt und danach der Treibspiegel 101 in Richtung auf den ersten Anschlusskontakt 40 bewegt wird. Das pyrotechnische Material wird dabei so dimensioniert, dass nach dem Aufbrechen bzw. Eindrücken des Trennbereichs 60 die Bewegung des Treibspiegels 101 die beiden Trennhälften ausreichend weit voneinander entfernt, im Zusammenwirken mit der Verdampfung des Löschmittels 90 dann sogar bis in eine Endposition.

Unmittelbar nach dem Aktivieren des pyrotechnischen Materials wird also der Trennbereich 60 zumindest teilweise aufgerissen bzw. eingedrückt. Erfolgt das Aufreißen bzw. Eindrücken nicht bereits vor Beginn der axialen Bewegung des Treibspiegels 101 über den vollständigen Umfang des Trennbereichs 60, so wird ein verbleibender Rest des Trennbereichs 60, der noch einen elektrischen Kontakt verursacht, durch die axiale Bewegung des Treibspiegels 101 vollständig aufgerissen, verstärkt durch die hier dann auftretende sehr schnelle Erhitzung des hier dann nur kleinen Restquerschnitts des Leiters durch den hier fließenden elektrischen Strom.

In der in Fig. 5 gezeigten Ausführungsform befindet sich in der Brennkammer 170 und in der Reaktionskammer 70 ein Löschmittel 90, das bei der Detonation bzw. Deflagration des pyrotechnischen Materials die Stoßwellenausbreitung begünstigt, so dass auf diese Weise weniger aktivierbares Material verwendet werden muss und die Wände des Trennbereichs 60 ausreichend dick gehalten werden können, so dass die Baugruppe auch noch bei hohen Betriebsströmen eingesetzt werden kann. Das Löschmittel 90 dient zur Dämpfung oder Löschung eines Lichtbogens zwischen den getrennten Enden des Trennbereichs 60.

Weiterhin kann in dem Hochstrom-Hochspannungsschalter 100 ein Kanal vorgesehen sein, der sich unterhalb des Treibspiegels 101, insbesondere im Flansch 140, vorzugsweise mittig in axialer Richtung erstreckt und die Brennkammer 170 mit einer Stauchkammer 180 unterhalb des Stauchbereichs 190 verbindet. Somit ist die Kontakteinheit 30 im dargestellten Ausführungsbeispiel weiter als durchgängiges Schaltrohr ausgebildet. In dieser Ausführungsform können sowohl die Brennkammer 170, der Kanal, die Reaktionskammer 70 und die Stauchkammer 180 mit dem Löschmittel 90 gefüllt sein. Der Kanal stellt sicher, dass bei der Auslösung des Hochstrom-Hochspannungsschalters 100 und der damit verbundenen Bewegung des Treibspiegels 101 von der Ausgangsposition in die Endposition das sich vergrößernde Volumen im Bereich der Brennkammer 170 und der Reaktionskammer 70 auch mit Löschmittel 90 nachgefüllt wird. Durch die Bewegung des Treibspiegels 101 von der Ausgangsposition in die Endposition wird Löschmittel 90 in der Stauchkammer 180 zusammengepresst und durch den Kanal in Richtung des Bereichs der Brennkammer 170 und hier direkt auf den Trennbereich 60 gespritzt. Auf diese Weise kann ein Lichtbogen zwischen den getrennten Teilen des Trennbereichs 60 zusätzlich gedämpft bzw. gelöscht werden.

Weiterhin sind in dem Hochstrom-Hochspannungsschalter 100 vorzugsweise Dichtelemente 230 zur Abdichtung der verschiedenen Kammern 70, 170 und 180 gegenüber dem Austritt von Löschmittel 90 und zur Abdichtung der verschiedenen Komponenten untereinander vorgesehen.

### Liste der Bezugszeichen:

| | |
|---|---|
| 1 | Stromkreis |
| S1 | erster Schalter |
| S2 | zweiter Schalter |
| 2 | Steuereinheit |
| L | induktive Last |
| W_{L} | Lastwiderstand |
| 3 | Spannungsverlauf der Kondensatorbank |
| 4 | Spannungsverlauf im ersten Schalter |
| 5 | Stromverlauf des gesamten Stromkreises |
| 6 | Zeitpunkt des Öffnens des ersten Schalters |
| 7 | Isolationsplateau |
| 8 | Schaltzeitpunkt des ersten Schalters |
| 9 | Schaltzeitpunkt des zweiten Schalters |
| 10 | Stromverlauf über den ersten und den zweiten Schalter |
| 11 | Energieeintrag in den ersten Schalter nach dem Schalten des ersten Schalters (falls der zweite Schalter nicht schaltet) |
| 12 | Energieabnahme des Magnetfeldes der induktiven Last nach dem Schalten des ersten Schalters |
| 13 | Stromverlauf über den ersten und den zweiten Schalter, falls der zweite Schalter schaltet |
| 14 | Energieeintrag in den zweiten Schalter nach dem Schalten des ersten Schalters |
| 15 | Energieabnahme des Magnetfeldes der induktiven Last nach dem Schalten des zweiten Schalters |
| 16 | maximale Energieaufnahme des ersten Schalters (falls der zweite Schalter nicht schaltet) |
| 17 | maximale Energieaufnahme des zweiten Schalters |
| 100 | Schalter (Hochstrom-Hochspannungsschalter/Batteriecutter) |
| 20 | Gehäuse |
| 30 | Kontakteinheit |
| 40 | erster Anschlusskontakt |
| 50 | zweiter Anschlusskontakt |
| 60 | Trennbereich |
| 60a | |
| 60b | 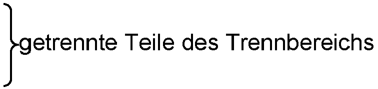 |
| 60c | |
| 70 | Reaktionskammer |
| 90 | Löschmittel |
| 101 | Treibspiegel |
| 110 | Antrieb |
| 120 | Stößel |
| 130 | Sollbruchstelle |
| 140 | Flansch |
| 150 | Flansch |
| 170 | Brennkammer |
| 180 | Stauchkammer |
| 190 | Stauchbereich |
| 200 | elektrische Anschlussleitungen |
| 220 | Isolatorelement |
| 230 | Dichtelement |
| 240 | Verschluss |
| 250 | Verschlusselement für Stauchkammer |

## Patentansprüche

1. Vorrichtung zum Trennen eines Stromkreises (1) mit induktiver Last (L) mit
(a) einem/r ersten und einem/r zweiten Schalter/Schaltgruppe (S1, S2), die in Reihe zueinander geschaltet sind und zum Trennen des Stromkreises (1) aus einem geschlossenen Zustand in einen Trennzustand überführt werden können, wobei keiner der Schalter/Schaltgruppen (S1, S2) so ausgebildet ist, dass er alleine in der Lage ist, den Stromkreis (1) sicher dauerhaft zu trennen, und
(b) einer Steuereinheit (2), die den zweiten Schalter/Schaltgruppe (S2) ansteuert und die so ausgebildet ist, dass der zweite Schalter/Schaltgruppe (S2) zeitlich nach dem ersten Schalter/Schaltgruppe (S1) aus dem geschlossenen Zustand in den Trennzustand überführt wird,
**dadurch gekennzeichnet,**
**dass** der erste Schalter/Schaltgruppe ein Hochstrom-Hochspannungsschalter ist, der in seinem Inneren im Bereich des Trennelements, durch dessen Trennung der Stromkreis getrennt wird, ein Löschmittel aufweist,
und **dass** die Steuereinheit (2) so ausgebildet ist, dass der zweite Schalter/Schaltgruppe (S2) spätestens aus dem geschlossenen Zustand in den Trennzustand überführt wird, bevor eine in den zweiten Schalter/Schaltgruppe (S2) eingebrachte Energiemenge erreicht wird, die zu dessen Zerstörung führt.

2. Vorrichtung nach Anspruch 1, worin der erste und der zweite Schalter/Schaltgruppe (S1, S2) aktiv durch einen ansteuerbaren Antrieb (110) aus dem geschlossenen Zustand in den Trennzustand überführbar sind.

3. Vorrichtung nach Anspruch 1 oder 2, worin der erste Schalter/Schaltgruppe (S1) passiv bei Überschreiten eines bestimmten Nennwertes des Stroms aus dem geschlossenen Zustand in den Trennzustand überführbar ist, und der zweite Schalter/Schaltgruppe (S2) aktiv durch einen ansteuerbaren Antrieb (110) aus dem geschlossenen Zustand in den Trennzustand überführbar ist.

4. Vorrichtung nach Anspruch 2 oder 3, worin die Steuereinheit (2) so ausgebildet ist, dass sie in Abhängigkeit eines bestimmten gemessenen Stroms oder einer bestimmten gemessenen Spannung durch den ersten Schalter/Schaltgruppe (S1) den zweiten Schalter/Schaltgruppe (S2) von dem geschlossenen Zustand in den Trennzustand überführt.

5. Vorrichtung nach Anspruch 4, worin die Steuereinheit (2) so ausgebildet ist, dass der zweite Schalter/Schaltgruppe (S2) von dem geschlossenen Zustand in den Trennzustand überführt wird, wenn der durch beide Schalter/Schaltgruppen (S1, S2) fließende Strom auf einen Wert im Bereich von 25% bis 40% des bei Trennbeginn des ersten Schalters/Schaltgruppe (S1) vorhandenen Stroms gefallen ist.

6. Vorrichtung nach Anspruch 4 oder 5, worin die Steuereinheit (2) so ausgebildet ist, dass der zweite Schalter/Schaltgruppe (S2) von dem geschlossenen Zustand in den Trennzustand überführt wird, wenn der durch beide Schalter/Schaltgruppen (S1, S2) fließende Strom auf einen Wert im Bereich von 5% bis 15% des bei Trennbeginn des ersten Schalters/Schaltgruppen (S1) vorhandenen Stroms gefallen ist.

7. Vorrichtung nach Anspruch 4, worin die Steuereinheit (2) so ausgebildet ist, dass sie in Abhängigkeit eines bestimmten gemessenen Stromabfalls im Stromkreis den zweiten Schalter/Schaltgruppe (S2) von dem geschlossenen Zustand in den Trennzustand überführt.

8. Vorrichtung nach den Ansprüchen 1 bis 7, **dadurch gekennzeichnet, dass** mehr als zwei Schalter/Schaltgruppen elektrisch in Reihe geschaltet sind und zeitlich hintereinander angesteuert werden können.

9. Stromkreis (1) mit einer Vorrichtung nach einem der Ansprüche 1 bis 8, einer Spannungsquelle, einem Lastwiderstand (W_{L}) und einer induktiven Last (L).

10. Verfahren zum Trennen eines Stromkreises (1) mit induktiver Last (L) mit einem/r ersten und einem/r zweiten Schalter/Schaltgruppe (S1, S2), die in Reihe zueinander geschaltet sind und zum Trennen des Stromkreises (1) aus einem geschlossenen Zustand in einen Trennzustand überführt werden, wobei keiner der Schalter/Schaltgruppen (S1, S2) so ausgebildet ist, dass er alleine in der Lage ist, den Stromkreis (1) sicher dauerhaft zu trennen, wobei der zweite Schalter/Schaltgruppe (S2) zeitlich nach dem ersten Schalter/Schaltgruppe (S1) aus dem geschlossenen Zustand in den Trennzustand überführt wird, **dadurch gekennzeichnet,**
**dass** der erste Schalter/Schaltgruppe ein Hochstrom-Hochspannungsschalter ist, der in seinem Inneren im Bereich des Trennelements, durch dessen Trennung der Stromkreis getrennt wird, ein Löschmittel aufweist,
und **dass** der zweite Schalter/Schaltgruppe (S1) spätestens aus dem geschlossenen Zustand in den Trennzustand überführt wird, bevor eine in den zweiten Schalter/Schaltgruppe (S2) eingebrachte Energiemenge erreicht wird, die zu dessen Zerstörung führt.

11. Verfahren nach Anspruch 10, worin der erste und der zweite Schalter/Schaltgruppe (S1, S2) aktiv durch einen ansteuerbaren Antrieb (110) aus dem geschlossenen Zustand in den Trennzustand überführt werden.

12. Verfahren nach Anspruch 10 oder 11, worin der erste Schalter/Schaltgruppe (S1) passiv bei Überschreiten eines bestimmten Nennwertes aus dem geschlossenen Zustand in den Trennzustand überführt wird, und der zweite Schalter/Schaltgruppe (S2) aktiv durch einen ansteuerbaren Antrieb (110) aus dem geschlossenen Zustand in den Trennzustand überführt wird.

13. Verfahren nach Anspruch 11 oder 12, worin der zweite Schalter/Schaltgruppe (S2) in Abhängigkeit eines bestimmten gemessenen Stroms oder einer bestimmten gemessenen Spannung durch den ersten Schalter/Schaltgruppe (S1) von dem geschlossenen Zustand in den Trennzustand überführt wird.

14. Verfahren nach Anspruch 13, worin der zweite Schalter/Schaltgruppe (S2) von dem geschlossenen Zustand in den Trennzustand überführt wird, wenn der durch beide Schalter/Schaltgruppen (S1, S2) fließende Strom auf einen Wert im Bereich von 25% bis 40% des bei Trennbeginn des ersten Schalters/Schaltgruppe (S1) vorhandenen Stroms gefallen ist.

15. Verfahren nach Anspruch 13 oder 14, worin die Steuereinheit (2) so ausgebildet ist, dass der zweite Schalter/Schaltgruppe (S2) von dem geschlossenen Zustand in den Trennzustand überführt wird, wenn der durch beide Schalter/Schaltgruppen (S1, S2) fließende Strom auf einen Wert im Bereich von 5% bis 15% des bei Trennbeginn des ersten Schalters/Schaltgruppe (S1) vorhandenen Stroms gefallen ist.

16. Verfahren nach Anspruch 13, worin die Steuereinheit (2) so ausgebildet ist, dass sie in Abhängigkeit eines bestimmten gemessenen Stromabfalls im Stromkreis den zweiten Schalter/Schaltgruppe (S2) von dem geschlossenen Zustand in den Trennzustand überführt.

17. Verfahren nach den Ansprüchen 10 bis 16, **dadurch gekennzeichnet, dass** mehr als zwei Schalter/Schaltgruppen elektrisch in Reihe geschaltet sind und zeitlich hintereinander angesteuert werden können.

## Claims

1. Device for disconnecting a circuit (1) having an inductive load (L), comprising
(a) a first and a second switch/switch group (S1, S2), which are connected in series with one another and can be transferred from a closed state into a disconnected state in order to disconnect the circuit (1), none of the switches/switch groups (S1, S2) being designed such that it alone is able to permanently disconnect the circuit (1), and
(b) a control unit (2) which controls the second switch/switch group (S2) and which is designed such that the second switch/switch group (S2) is transferred from the closed state into the disconnected state subsequently to the first switch/switch group (S1),
**characterized in that**
the first switch/switch group is a high-current high-voltage switch which, in its interior, has an extinguishing agent in the region of the disconnecting element, via the disconnection of which the circuit is disconnected,
**and in that** the control unit (2) is designed such that the second switch/switch group (S2) is transferred from the closed state into the disconnected state at the latest before an amount of energy introduced into the second switch/switch group (S2) is reached which leads to the destruction thereof.

2. Device according to claim 1, wherein the first and the second switch/switch group (S1, S2) can actively be transferred from the closed state into the disconnected state by a controllable drive (110).

3. Device according to either claim 1 or claim 2, wherein the first switch/switch group (S1) can passively be transferred from the closed state into the disconnected state when a certain rated value of the current is exceeded, and the second switch/switch group (S2) can actively be transferred from the closed state into the disconnected state by a controllable drive (110).

4. Device according to either claim 2 or claim 3, wherein the control unit (2) is designed such that it transfers the second switch/switch group (S2) from the closed state into the disconnected state depending on a certain measured current or a certain measured voltage by the first switch/switch group (S1).

5. Device according to claim 4, wherein the control unit (2) is designed such that the second switch/switch group (S2) is transferred from the closed state into the disconnected state when the current flowing through both switches/switch groups (S1, S2) has fallen to a value in the range of from 25% to 40% of the current present at the start of the disconnection of the first switch/switch group (S1).

6. Device according to either claim 4 or claim 5, wherein the control unit (2) is designed such that the second switch/switch group (S2) is transferred from the closed state into the disconnected state when the current flowing through both switches/switch groups (S1, S2) has fallen to a value in the range of from 5% to 15% of the current present at the start of the disconnection of the first switch/switch group (S1).

7. Device according to claim 4, wherein the control unit (2) is designed such that it transfers the second switch/switch group (S2) from the closed state into the disconnected state depending on a certain measured current drop in the circuit.

8. Device according to claims 1 to 7, **characterized in that** more than two switches/switch groups are electrically connected in series and can be controlled in temporal succession.

9. Circuit (1) comprising a device according to any of claims 1 to 8, a voltage source, a load resistor (W_{L}) and an inductive load (L).

10. Method for disconnecting a circuit (1) having an inductive load (L) with a first and a second switch/switch group (S1, S2), which are connected in series with one another and which are transferred from a closed state into a disconnected state in order to disconnect the circuit (1), wherein none of the switches/switch groups (S1, S2) is designed such that it alone is able to permanently disconnect the circuit (1), wherein the second switch/switch group (S2) is transferred from the closed state into the disconnected state subsequently to the first switch/switch group (S1), **characterized in that**
the first switch/switch group is a high-current high-voltage switch which, in its interior, has an extinguishing agent in the region of the disconnecting element, via the disconnection of which the circuit is disconnected,
**and in that** the second switch/switch group (S1) is transferred from the closed state into the disconnected state at the latest before an amount of energy introduced into the second switch/switch group (S2) is reached which leads to the destruction thereof.

11. Method according to claim 10, wherein the first and the second switch/switch group (S1, S2) are actively transferred from the closed state into the disconnected state by a controllable drive (110).

12. Method according to either claim 10 or claim 11, wherein the first switch/switch group (S1) is passively transferred from the closed state into the disconnected state when a certain nominal value is exceeded, and the second switch/switch group (S2) is actively transferred from the closed state into the disconnected state by a controllable drive (110).

13. Method according to either claim 11 or claim 12, wherein the second switch/switch group (S2) is transferred from the closed state into the disconnected state depending on a certain measured current or a certain measured voltage by the first switch/switch group (S1).

14. Method according to claim 13, wherein the second switch/switch group (S2) is transferred from the closed state into the disconnected state when the current flowing through both switches/switch groups (S1, S2) has fallen to a value in the range of from 25% to 40% of the current present at the start of the disconnection of the first switch/switch group (S1).

15. Method according to either claim 13 or claim 14, wherein the control unit (2) is designed such that the second switch/switch group (S2) is transferred from the closed state into the disconnected state when the current flowing through both switches/switch groups (S1, S2) has fallen to a value in the range of from 5% to 15% of the current present at the start of the disconnection of the first switch/switch group (S1).

16. Method according to claim 13, wherein the control unit (2) is designed such that it transfers the second switch/switch group (S2) from the closed state into the disconnected state depending on a certain measured current drop in the circuit.

17. Method according to claims 10 to 16, **characterized in that** more than two switches/switch groups are electrically connected in series and can be controlled in temporal succession.

## Revendications

1. Dispositif permettant de déconnecter un circuit électrique (1) à charge inductive (L) comportant
(a) un premier et un second commutateur/groupe de commutation (S1, S2) qui sont connectés en série l'un à l'autre et peuvent être transférés d'un état fermé à un état de déconnexion pour la déconnexion du circuit électrique (1), aucun des commutateurs/groupes de commutation (S1, S2) n'étant conçu de manière à pouvoir déconnecter tout seul de manière sécurisée et permanente le circuit électrique (1), et
(b) une unité de commande (2) qui commande le second commutateur/groupe de commutation (S2) et qui est conçue de telle sorte que le second commutateur/groupe de commutation (S2) est transféré de l'état fermé à l'état de déconnexion chronologiquement après le premier commutateur/groupe de commutation (S1),
**caractérisé en ce**
**que** le premier commutateur/groupe de commutation est un commutateur haute tension à courant élevé qui présente un agent extincteur, lequel se trouve à l'intérieur du commutateur/groupe de commutation dans la zone de l'élément de déconnexion dont la déconnexion permet de déconnecter le circuit électrique,
**et en ce que** l'unité de commande (2) est conçue de telle sorte que le second commutateur/groupe de commutation (S2) est transféré de l'état fermé à l'état de déconnexion au plus tard avant qu'une quantité d'énergie introduite dans le second commutateur/groupe de commutation (S2) soit atteinte, laquelle énergie entraîne la détérioration de celui-ci.

2. Dispositif selon la revendication 1, dans lequel les premier et second commutateurs/groupes de commutation (S1, S2) peuvent être transférés de manière active de l'état fermé à l'état de déconnexion par un entraînement (110) pouvant être commandé.

3. Dispositif selon la revendication 1 ou 2, dans lequel le premier commutateur/groupe de commutation (S1) peut être transféré de manière passive de l'état fermé à l'état de déconnexion en cas de dépassement d'une valeur nominale déterminée du courant, et le second commutateur/groupe de commutation (S2) peut être transféré de manière active de l'état fermé à l'état de déconnexion par un entraînement (110) pouvant être commandé.

4. Dispositif selon la revendication 2 ou 3, dans lequel l'unité de commande (2) est conçue de manière à transférer le second commutateur/groupe de commutation (S2) de l'état fermé à l'état de déconnexion à travers le premier commutateur/groupe de commutation (S1), en fonction d'un courant mesuré déterminé ou d'une tension mesurée déterminée.

5. Dispositif selon la revendication 4, dans lequel l'unité de commande (2) est conçue de sorte que le second commutateur/groupe de commutation (S2) est transféré de l'état fermé à l'état de déconnexion lorsque le courant qui traverse les deux commutateurs/groupes de commutation (S1, S2) a chuté à une valeur située dans la plage de 25 % à 40 % du courant disponible au début de déconnexion du premier commutateur/groupe de commutation (S1).

6. Dispositif selon la revendication 4 ou 5, dans lequel l'unité de commande (2) est conçue de sorte que le second commutateur/groupe de commutation (S2) est transféré de l'état fermé à l'état de déconnexion lorsque le courant qui traverse les deux commutateurs/groupes de commutation (S1, S2) a chuté à une valeur située dans la plage de 5 % à 15 % du courant disponible au début de déconnexion du premier commutateur/groupe de commutation (S1).

7. Dispositif selon la revendication 4, dans lequel l'unité de commande (2) est conçue de manière à transférer le second commutateur/groupe de commutation (S2) de l'état fermé à l'état de déconnexion en fonction d'une chute de courant mesurée déterminée dans le circuit électrique.

8. Dispositif selon les revendications 1 à 7, **caractérisé en ce que** plus de deux commutateurs/groupes de commutation sont connectés électriquement en série et peuvent être commandés chronologiquement l'un après l'autre.

9. Circuit électrique (1) comportant un dispositif selon l'une des revendications 1 à 8, une source de tension, une résistance de charge (W_{L}) et une charge inductive (L).

10. Procédé permettant de déconnecter un circuit électrique (1) à charge inductive (L) comportant un premier et un second commutateur/groupe de commutation (S1, S2) qui sont connectés en série l'un à l'autre et sont transférés d'un état fermé à un état de déconnexion pour la déconnexion du circuit électrique (1), aucun des commutateurs/groupes de commutation (S1, S2) n'étant conçu de manière à pouvoir déconnecter tout seul de manière sécurisée et permanente le circuit électrique (1), le second commutateur/groupe de commutation (S2) étant transféré de l'état fermé à l'état de déconnexion chronologiquement après le premier commutateur/groupe de commutation (S1), **caractérisé en ce**
**que** le premier commutateur/groupe de commutation est un commutateur haute tension à courant élevé qui présente un agent extincteur, lequel se trouve à l'intérieur du commutateur/groupe de commutation dans la zone de l'élément de déconnexion dont la déconnexion permet de déconnecter le circuit électrique,
**et en ce que** le second commutateur/groupe de commutation (S1) est transféré de l'état fermé à l'état de déconnexion au plus tard avant qu'une quantité d'énergie introduite dans le second commutateur/groupe de commutation (S2) soit atteinte, laquelle énergie entraîne la détérioration de celui-ci.

11. Procédé selon la revendication 10, dans lequel les premier et second commutateurs/groupes de commutation (S1, S2) sont transférés de manière active de l'état fermé à l'état de déconnexion par un entraînement (110) pouvant être commandé.

12. Procédé selon la revendication 10 ou 11, dans lequel le premier commutateur/groupe de commutation (S1) est transféré de manière passive de l'état fermé à l'état de déconnexion en cas de dépassement d'une valeur nominale déterminée, et le second commutateur/groupe de commutation (S2) est transféré de manière active de l'état fermé à l'état de déconnexion par un entraînement (110) pouvant être commandé.

13. Procédé selon la revendication 11 ou 12, dans lequel le second commutateur/groupe de commutation (S2) est transféré de l'état fermé à l'état de déconnexion à travers le premier commutateur/groupe de commutation (S1), en fonction d'un courant mesuré déterminé ou d'une tension mesurée déterminée.

14. Procédé selon la revendication 13, dans lequel le second commutateur/groupe de commutation (S2) est transféré de l'état fermé à l'état de déconnexion lorsque le courant qui traverse les deux commutateurs/groupes de commutation (S1, S2) a chuté à une valeur située dans la plage de 25 % à 40 % du courant disponible au début de déconnexion du premier commutateur/groupe de commutation (S1).

15. Procédé selon la revendication 13 ou 14, dans lequel l'unité de commande (2) est conçue de sorte que le second commutateur/groupe de commutation (S2) est transféré de l'état fermé à l'état de déconnexion lorsque le courant qui traverse les deux commutateurs/groupes de commutation (S1, S2) a chuté à une valeur située dans la plage de 5 % à 15 % du courant disponible au début de déconnexion du premier commutateur/groupe de commutation (S1).

16. Procédé selon la revendication 13, dans lequel l'unité de commande (2) est conçue de manière à transférer le second commutateur/groupe de commutation (S2) de l'état fermé à l'état de déconnexion en fonction d'une chute de courant mesurée déterminée dans le circuit électrique.

17. Procédé selon les revendications 10 à 16, **caractérisé en ce que** plus de deux commutateurs/groupes de commutation sont connectés électriquement en série et peuvent être commandés chronologiquement l'un après l'autre.
